# FASCICULE DE BREVET EUROPEEN

(11) **EP 2 308 798 B1**
(45) Date de publication et mention de la délivrance du brevet: **10.01.2018**
(21) Numéro de dépôt: 10186344.7
(22) Date de dépôt: 04.10.2010
(51) Int. Cl.: B81C 1/00, H01J 29/94, H01L 23/26, H01L 23/10

(54) **Procédé de traitement d'un matériau getter et procédé d'encapsulation d'un tel matériau getter**
Behandlungsverfahren eines Getter-Materials, und Verkapselungsverfahren eines solchen Getter-Materials
Method for treating a getter material and method for encapsulating such a getter material

(30) Priorité: 07.10.2009 FR 0956997
(43) Date de publication de la demande: 13.04.2011
(73) Titulaire: Commissariat à l'Énergie Atomique et aux Énergies Alternatives, 75015 Paris (FR)
(72) Inventeur: Baillin, Xavier, 38920 Crolles (FR); Lagoutte, Emmanuelle, 38160 ST Marcellin (FR); Rodriguez, Guillaume, 38190 Le Champ pres Froges (FR)
(74) Mandataire: Ilgart, Jean-Christophe

(56) Documents cités:
- EP-A1- 1 640 333
- WO-A1-01/54178
- WO-A2-2006/089068
- FR-A1- 2 883 099
- US-A- 3 408 130
- US-A1- 2003 138 656
- US-B1- 6 499 354
- US-B1- 7 595 209
- HENMI H ET AL: "VACUUM PACKAGING FOR MICROSENSORS BY GLASS-SILICON ANODIC BONDING", SENSORS AND ACTUATORS A, ELSEVIER SEQUOIA S.A., LAUSANNE, CH LNKD- DOI:10.1016/0924-4247(94)80003-0, vol. A43, no. 1/03, 1 mai 1994 (1994-05-01), pages 243-248, XP000454118, ISSN: 0924-4247

## Description

### DOMAINE TECHNIQUE

L'invention concerne le domaine des matériaux getter utilisés pour réaliser une absorption et/ou une adsorption gazeuse, par exemple dans une cavité fermée dans laquelle est encapsulé un dispositif microélectronique et/ou nanoélectronique. L'invention porte plus particulièrement sur la réalisation d'un traitement de protection de tels matériaux getter.

### ÉTAT DE LA TECHNIQUE ANTÉRIEURE

Lorsque l'on réalise une encapsulation d'un dispositif microélectronique et/ou nanoélectronique par exemple de type MEMS (microsystème électromécanique) et/ou NEMS (nanosystème électromécanique) et/ou MOEMS (microsystème opto-électromécanique) et/ou NOEMS (nanosystème opto-électromécanique) dans une cavité fermée hermétiquement, il est connu de déposer un matériau getter en couche mince à l'intérieur de la cavité, soit à coté du dispositif, soit contre le capot de la cavité comme cela est décrit dans les documents US 6 897 551 B2 et WO 2009/087284 A1. Un matériau getter est un matériau comportant, de façon intrinsèque et/ou de par sa morphologie microscopique ou nanoscopique, des propriétés absorbantes et/ou adsorbantes vis-à-vis de molécules gazeuses, pouvant ainsi réaliser une pompe de gaz chimique lorsque celui-ci est disposé dans un environnement clos. Un tel matériau getter permet donc de contrôler la pression dans une cavité dans laquelle est encapsulé un dispositif microélectronique et/ou nanoélectronique. Des matériaux getter non évaporables sont par exemple des métaux tels que du titane, du zirconium, du vanadium, ou encore des alliages métalliques de ces métaux ou d'autres métaux adaptés.

Un getter réalisé en couche mince a pour inconvénient de présenter une forte réactivité avec l'air ambiant. Ainsi, après sa réalisation, si un matériau getter en couche mince est exposé à l'air ambiant, le matériau getter absorbe alors les gaz de l'air ambiant (oxygène, azote, monoxyde et dioxyde de carbone) ainsi que la vapeur d'eau présente dans l'air ambiant. Par exemple, si le matériau getter est à base de titane, la réaction chimique du matériau getter avec la vapeur d'eau est :

Ti (solide) + H₂O (gaz) → TiOₓ + yH (1)

Une telle exposition du matériau getter à l'air ambiant forme une couche d'oxyde de quelques nanomètres d'épaisseur en surface de la couche de matériau getter. De plus, des molécules d'hydrogène se dissolvent dans le matériau getter. La même réaction est obtenue lorsque le matériau getter est à base de zirconium ou de tout autre matériau getter. La présence d'hydrogène dans le matériau getter pose un problème car cet hydrogène est relâché par le matériau getter par un phénomène de désorption lorsqu'il est soumis à une température proche de sa température d'activation et sous vide secondaire, c'est-à-dire à une pression comprise entre environ 10⁻³ mbar et 10⁻⁷ mbar, ces conditions étant fréquemment rencontrées lors de l'encapsulation du dispositif et/ou lors de l'activation thermique du matériau getter. Il est possible qu'un tel dégazage soit consécutif et/ou simultané à la dissolution de l'oxyde dans le matériau getter lors de son activation. Or, un tel dégazage d'hydrogène apparaissant après la fermeture de la cavité dans laquelle est encapsulé le dispositif peut être néfaste pour le fonctionnement du dispositif. De plus, la formation de l'oxyde dans le matériau getter par une exposition à l'air ambiant est mal contrôlée car elle dépend, entre autre, de la pression partielle de vapeur d'eau dans l'atmosphère ambiante qui est aléatoire.

Lorsque le matériau getter a été exposé à l'air ambiant, il est possible de réaliser un dégazage du matériau getter préalablement à son encapsulation avec le dispositif pour éliminer les particules gazeuses qui ont contaminé le matériau getter. Toutefois, un tel dégazage ne peut être obtenu que par un traitement thermique du matériau getter pendant plusieurs heures, ce qui représente un inconvénient pour la mise en oeuvre du procédé d'encapsulation.

Le document US 6 923 625 B2 décrit une solution pour protéger le matériau getter d'une contamination par l'air ambiant telle qu'une oxydation du matériau getter, en déposant une couche mince à base d'un métal noble contre le matériau getter. Cette solution nécessite d'une part de réaliser un dépôt supplémentaire qui, en plus du surcoût engendré, nécessite une forte maîtrise de l'épaisseur de la couche protectrice en métal noble, et d'autre part peut ajouter des difficultés pour la mise en forme du getter par photolithographie et gravure, ou encore poser des problèmes de compatibilité avec l'empilement technologique réalisé pour construire le micro-dispositif encapsulé.

Le document US 3 408 130 décrit un procédé d'oxydation de grains de zirconium mis en oeuvre sous atmosphère de dioxygène.

### EXPOSÉ DE L'INVENTION

Un but de la présente invention est de proposer un procédé permettant de protéger efficacement un matériau getter, par exemple destiné à être encapsulé dans une cavité dans laquelle un dispositif microélectronique et/ou nanoélectronique peut également être encapsulé, vis-à-vis de l'air ambiant et en particulier vis-à-vis de la vapeur d'eau présente dans l'air ambiant, mais également de protéger ce matériau getter de toute altération chimique pouvant être provoquée par des gaz extérieurs.

Pour cela, on propose selon la revendication 1 un procédé de traitement d'un matériau getter, comportant au moins une étape d'oxydation et/ou de nitruration du matériau getter mise en oeuvre sous atmosphère sèche de dioxygène et/ou de diazote, formant une couche de protection à base d'oxyde et/ou de nitrure du matériau getter.

On entend par « atmosphère sèche de dioxygène et/ou de diazote » une atmosphère sous pression partielle faible ou nulle de vapeur d'eau (par exemple inférieure à environ 10⁻⁵ mbar).

Un tel procédé de traitement permet donc de former une couche de protection à base d'oxyde et/ou de nitrure pouvant absorber et/ou adsorber de façon réversible des molécules gazeuses, par exemple celles de l'air ambiant, protégeant toute la surface du matériau getter de toute altération par ces molécules gazeuses. Les molécules absorbées et/ou adsorbées par la couche de protection à base d'oxyde et/ou de nitrure pourront être désorbées par la mise en oeuvre ultérieure d'un simple dégazage. Un tel procédé de traitement autorise donc d'exposer par la suite le matériau getter à l'air ambiant sans que celui-ci ne soit altéré par les gaz de l'air ambiant, ce qui supprime la contrainte technologique qui consistait à enchaîner la réalisation de l'encapsulation du matériau getter juste après la réalisation du matériau getter pour éviter une exposition du matériau getter à l'air ambiant.

Par rapport à une oxydation du matériau getter se produisant en exposant le matériau getter à l'air ambiant, l'oxydation et/ou la nitruration réalisées par voie sèche, c'est-à-dire réalisées dans un environnement clos comportant de l'oxygène sec et/ou du diazote sec, ne diffusent pas de molécules d'hydrogène dans le matériau getter. Ainsi, aucun dégazage pour éliminer spécifiquement ces molécules d'hydrogène n'est nécessaire avant d'encapsuler le matériau getter.

Un tel procédé de traitement permet également d'augmenter la capacité de pompage du matériau getter par rapport à un matériau getter non protégé et exposé à l'air ambiant.

Enfin, le matériau getter ainsi protégé peut être activé thermiquement à partir d'une température d'activation plus basse, par exemple inférieure d'environ 20°C à 30°C, que la température d'activation d'un matériau getter non protégé et exposé à l'air ambiant.

Avantageusement, pour obtenir cette pression partielle faible ou nulle de vapeur d'eau, le procédé peut comporter, avant l'étape d'oxydation et/ou de nitruration, une étape de mise sous vide ou de maintien sous vide de l'environnement dans lequel se trouve le matériau getter. Ainsi, l'étape d'oxydation et/ou de nitruration peut être mise en oeuvre dans un environnement sous vide.

L'étape d'oxydation est mise en oeuvre à une pression supérieure à environ 10⁻² mbar et/ou à une température comprise entre environ 50°C et 120°C et pendant une durée comprise entre environ 1 minute et 10 minutes, le matériau getter étant à base de titane et/ou de zirconium. Ces paramètres correspondent au fait que la cinétique d'oxydation du titane dans cette gamme de températures reste la même. De plus, la surface peut apparaître saturée en espèces adsorbées à partir d'environ 10⁻² mbar pour un temps d'exposition proche d'une minute. Ainsi, en choisissant en plus une température comprise entre environ 50°C et 120°C, et avantageusement 100°C, on forme une couche de protection suffisamment épaisse pour absorber et/ou adsorber les molécules gazeuses auxquelles le matériau getter est exposé, et suffisamment fine pour celle-ci ne forme pas une barrière à l'effet getter ni ne contribue à augmenter la température d'activation thermique du matériau getter et à limiter sa capacité d'absorption et/ou d'adsorption. La couche de protection ainsi formée peut avoir une épaisseur comprise entre environ un et quelques nanomètres, par exemple inférieure à environ 10 nm.

L'étape de nitruration est réalisée selon les paramètres indiqués ci-dessus, et de préférence à une température comprise entre environ 100°C et 120°C, le matériau getter étant à base de titane et/ou de zirconium.

Le procédé peut comporter en outre, lorsque le matériau getter est exposé à l'air ambiant avant la mise en oeuvre de l'étape d'oxydation et/ou de nitruration, une étape de traitement thermique du matériau getter à une température proche de sa température d'activation, et par exemple égale à environ sa température d'activation, et sous vide secondaire mise en oeuvre avant l'étape d'oxydation et/ou de nitruration du matériau getter. Un tel traitement thermique permet de désorber et/ou de dissoudre les espèces gazeuses ayant été adsorbées et/ou transformées en oxyde et/ou en nitrure par un matériau getter n'ayant pas encore subi le procédé de traitement formant la couche de protection à base d'oxyde et/ou de nitrure. Dans ce cas, l'étape de traitement thermique peut être mise en oeuvre pendant une durée comprise entre environ 1 heure et 10 heures.

Le procédé de traitement peut être mis en oeuvre pour tous types de matériaux getter. Le matériau getter peut notamment être réalisé en couche mince. Le matériau getter peut comporter une taille de grains inférieure ou égale à environ 200 nm.

L'invention concerne également un procédé d'encapsulation d'un matériau getter dans une cavité, comportant au moins les étapes de :
- dépôt d'au moins le matériau getter sur une face d'une couche destinée à former une paroi de la cavité ;
- mise en oeuvre d'un procédé de traitement du matériau getter tel que décrit ci-dessus ;
- fermeture de la cavité dans laquelle est disposé le matériau getter.

La cavité peut être obtenue soit par report d'un capot sur un substrat, soit par dépôt sur le substrat d'une couche sacrificielle puis d'une couche capot (ou couche de fermeture) puis par une élimination de la couche sacrificielle. Dans cette seconde variante, l'étape de fermeture peut alors consister à fermer des trous de libération permettant d'éliminer la couche sacrificielle et formés dans la couche capot. Dans ce cas, la couche de protection du matériau getter permet non seulement de protéger le getter de l'humidité mais aussi de protéger le getter des étapes de réalisation et de libération de la couche sacrificielle.

Le procédé peut comporter en outre, entre le procédé de traitement du matériau getter et l'étape de fermeture de la cavité, la mise en oeuvre d'une étape de traitement thermique du matériau getter à une température inférieure d'environ 50°C à 150°C par rapport à la température d'activation du matériau getter et sous vide secondaire. Un tel traitement thermique permet notamment de désorber les molécules gazeuses qui ont été adsorbées et/ou absorbées par la couche de protection lorsque le matériau getter était exposé à l'air ambiant après la réalisation de la couche de protection, tout en évitant d'activer le matériau getter lors de cette phase de dégazage.

L'étape de traitement thermique du matériau getter réalisée entre le procédé de traitement du matériau getter et l'étape de fermeture de la cavité peut être mise en oeuvre pendant une durée comprise entre environ quelques minutes et quelques dizaines de minutes, par exemple entre environ 2 mn et 50 mn.

Le procédé peut comporter en outre, après la mise en oeuvre du procédé de traitement du matériau getter ou, lorsque le procédé comporte une étape de traitement thermique du matériau getter mise en oeuvre entre le procédé de traitement du matériau getter et l'étape de fermeture de la cavité, après ladite étape de traitement thermique du matériau getter, une étape d'activation thermique du matériau getter. Outre l'activation thermique proprement dite du matériau getter, cette étape permet également au matériau getter d'absorber les molécules d'oxygène et/ou d'azote formant les particules d'oxyde et/ou de nitrure de la couche de protection, permettant ainsi d'obtenir un matériau getter homogène, et donc de supprimer la couche de protection. De plus, cette étape d'activation thermique du matériau getter peut être réalisée pendant l'étape de fermeture de la cavité.

L'activation thermique du matériau getter peut être réalisée en chauffant le matériau getter à une température comprise entre environ 200°C et 450°C.

Un dispositif microélectronique et/ou nanoélectronique peut également être encapsulé dans la cavité.

Il est également proposé un matériau getter comportant au moins en surface une couche de protection à base d'au moins un oxyde non natif et/ou de nitrure du matériau getter. Le terme « oxyde non natif » désigne un oxyde qui n'est pas formé naturellement à l'air ambiant, mais qui est par exemple formé par une étape d'oxydation sous atmosphère sèche de dioxygène et/ou de diazote telle que décrite précédemment.

La couche de protection peut avoir une épaisseur comprise entre environ 1 nm et 10 nm.

Ledit matériau getter peut être réalisé en couche mince et/ou être à base de titane et/ou de zirconium et/ou de vanadium.

L'invention concerne également une structure d'encapsulation comportant au moins une cavité dans laquelle est disposé un matériau getter tel que décrit ci-dessus.

La structure d'encapsulation peut comporter en outre au moins un dispositif microélectronique et/ou nanoélectronique encapsulé dans la cavité.

### BRÈVE DESCRIPTION DES DESSINS

La présente invention sera mieux comprise à la lecture de la description d'exemples de réalisation donnés à titre purement indicatif et nullement limitatif en faisant référence aux dessins annexés sur lesquels :
- les figures 1 à 3 représentent les étapes d'un procédé d'encapsulation d'un matériau getter, objet de la présente invention, selon un mode de réalisation particulier,
- la figure 4 représente les capacités de pompage de l'azote de différents matériaux getter protégés ou non par une couche d'oxydation ou de nitruration en fonction de la température d'activation thermique des matériaux getter.

Des parties identiques, similaires ou équivalentes des différentes figures décrites ci-après portent les mêmes références numériques de façon à faciliter le passage d'une figure à l'autre.

Les différentes parties représentées sur les figures ne le sont pas nécessairement selon une échelle uniforme, pour rendre les figures plus lisibles.

Les différentes possibilités (variantes et modes de réalisation) doivent être comprises comme n'étant pas exclusives les unes des autres et peuvent se combiner entre elles.

### EXPOSÉ DÉTAILLÉ DE MODES DE RÉALISATION PARTICULIERS

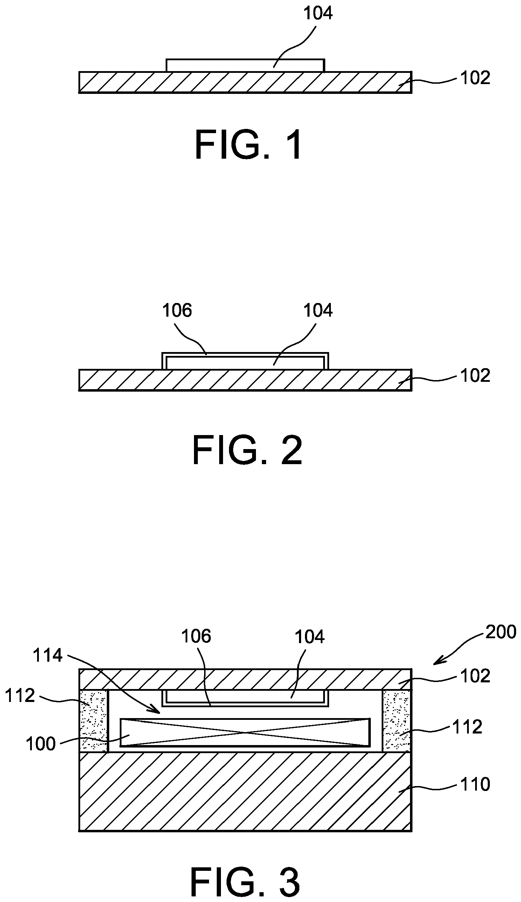

On se réfère aux figures 1 à 3 qui représentent les étapes d'un procédé d'encapsulation d'un matériau getter 104 et d'un dispositif microélectronique et/ou nanoélectronique 100, par exemple de type MEMS et/ou NEMS et/ou MOEMS et/ou NOEMS, selon un mode de réalisation particulier.

Comme représenté sur la figure 1, on réalise le dépôt du matériau getter 104 sur un substrat 102 destiné à former le capot d'une cavité dans laquelle le matériau getter 104 et le dispositif 100 sont destinés à être encapsulés. Le matériau getter 104, ici du titane, est par exemple réalisé par un dépôt lift-off (dépôt à travers un masque sacrificiel réalisé sur le substrat 102) ou par un dépôt à travers un pochoir, sous la forme d'une couche mince, c'est-à-dire dont l'épaisseur est inférieure ou égale à environ 10 µm. Il est également possible que le matériau getter 104 puisse être formé par lithographie et gravure.

On réalise ensuite un traitement du matériau getter 104 afin que celui-ci soit protégé notamment de l'air ambiant. Pour cela, on injecte du dioxygène sec (O₂) et/ou du diazote sec (N₂) dans la chambre de dépôt à une température comprise entre environ 50°C et 120°C, et par exemple égale à environ 100°C, la pression régnant dans la chambre de dépôt étant par exemple au minimum égale à environ 10⁻² mbar. En plaçant le matériau getter 104 en présence de dioxygène et/ou de diazote pendant une durée de quelques minutes, par exemple comprise entre environ 1 mn et 10 mn, on réalise une oxydation et/ou une nitruration par voie sèche du matériau getter 104, formant, comme cela est représenté sur la figure 2, une couche de protection 106 à base d'oxyde de titane et/ou de nitrure de titane sur la surface du matériau getter 104. L'épaisseur de la couche de protection 106 est par exemple comprise entre environ 1 nm et quelques nanomètres, et par exemple inférieure à environ 10 nm. Les réactions d'oxydation et de nitruration du titane correspondent aux équations suivantes :

Ti (solide) + O₂ (gaz) → TiₓO_{y} (solide) (2)

Ti (solide) + N₂ (gaz) → Ti_{w}N_{z} (solide) (3)

Les indices x, y, w et z représentent la possibilité d'avoir des composés non stoechiométriques, par rapport aux composés attendus, à savoir le TiO₂ et le TiN. La couche de protection 106 ainsi formée permet, en cas d'exposition ultérieure du matériau getter 104 à l'air ambiant, de le protéger des altérations chimiques pouvant être causées par les gaz présents notamment dans l'air ambiant car ces gaz sont alors absorbés et/ou adsorbés par la couche de protection 106 sans polluer le matériau getter 104, mais aussi par les produits chimiques utilisés en photolithographie. Il est donc possible de stocker le substrat 102 et le matériau getter 104 à l'air ambiant avant d'utiliser le substrat 102 pour former la cavité dans laquelle le dispositif 100 et le matériau getter 104 sont destinés à être encapsulés.

Comme représenté sur la figure 3, on réalise l'assemblage du substrat 102 avec un second substrat 110 dans lequel est réalisé le dispositif 100, formant une structure d'encapsulation 200. Cet assemblage est réalisé en solidarisant le substrat 102 au second substrat 110 par l'intermédiaire d'un cordon de scellement 112, formant une cavité 114 hermétique dans laquelle sont encapsulés le dispositif 100 et le matériau getter 104. Au cours de cet assemblage, un traitement thermique sous vide secondaire, par exemple réalisé à une température inférieure d'environ 50°C à 150°C par rapport à la température d'activation du matériau getter pendant une durée comprise entre environ quelques minutes et quelques dizaines de minutes, est mis en oeuvre afin de désorber les gaz adsorbés et/ou absorbés par la couche de protection 106 lorsque celle-ci était exposée à l'air ambiant. Ainsi, ces gaz sont évacués avant que la cavité 114 ne soit fermée hermétiquement.

L'encapsulation est ensuite achevée en réalisant une activation thermique du matériau getter 104 par l'intermédiaire d'un recuit du matériau getter 104 à une température par exemple comprise entre environ 200°C et 450°C et choisie en fonction de la nature du matériau getter. Outre l'activation thermique du matériau getter 104, ce recuit permet également de « dissoudre » la couche de protection 106, c'est-à-dire de supprimer la couche de protection 106, les molécules d'oxygène et/ou d'azote présentes dans la couche de protection 106 sous la forme de particules d'oxyde et/ou de nitrure étant alors absorbées par l'ensemble du matériau getter 104, ce qui permet de retrouver un matériau getter 104 uniforme, ici à base de titane.

Dans l'exemple décrit ci-dessus en liaison avec les figures 1 à 3, le matériau getter 104 est mis en forme directement lors de son dépôt sur le substrat 102, puis oxydé et/ou nitruré par du dioxyde sec et/ou du diazote sec. Dans une variante, il est possible que le matériau getter soit tout d'abord déposé sous la forme d'une couche mince recouvrant complètement le substrat 102. Le matériau getter 104 est ensuite oxydé et/ou nitruré par du dioxyde sec et/ou du diazote sec, formant la couche de protection 106, puis mis en forme par photolithographie et gravure soit par voie sèche, réactive ou non, soit par voie humide. La couche d'oxyde et/ou de nitrure 106 formée ne modifie pas le comportement du matériau getter 104 vis-à-vis de la gravure réalisée.

Dans le procédé précédemment décrit, la formation de la couche de protection 106 à base d'oxyde et/ou de nitrure est formée in-situ dans la chambre de dépôt du matériau getter 104. Toutefois, le procédé permettant de former la couche de protection 106 peut également s'appliquer à des matériaux getter ayant été préalablement exposés à l'air ambiant. Dans ce cas, on met en oeuvre, préalablement à la formation de la couche de protection 106, un traitement thermique dans une enceinte sous vide secondaire à une température par exemple égale à environ 350°C pendant plusieurs heures. A la fin de ce traitement thermique, l'oxydation et/ou la nitruration par voie sèche telle que décrites précédemment pour former la couche de protection 106 sont alors mises en oeuvre en conservant le matériau getter dans l'enceinte sous vide afin de ne pas réexposer le matériau getter à l'air ambiant. Lors de la réalisation de la couche de protection 106, le vide formé dans l'enceinte est ajusté à une pression supérieure à environ 10⁻² mbar et la température est ajustée afin qu'elle soit comprise entre environ 50°C et 120°C, et de préférence égale à environ 100°C.

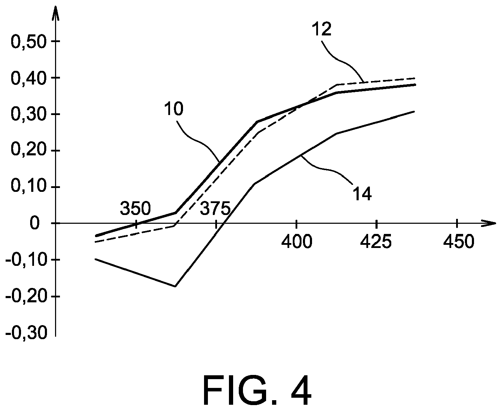

La réalisation de la couche de protection 106 à base d'oxyde et/ou de nitrure permet également d'augmenter la capacité de pompage du matériau getter. La courbe 10 tracée sur la figure 4 représente la capacité de pompage (en mbar.cm³/cm²) du matériau getter 104 en fonction de la température d'activation thermique (en °C) du matériau getter 104, lorsque la couche de protection 106 est à base de d'oxyde de titane (c'est-à-dire formée par oxydation sèche du matériau getter 104). La courbe 12 représente la capacité de pompage de ce même matériau getter 104, mais avec une couche de protection 106 est à base de nitrure de titane (c'est-à-dire formée par nitruration sèche du matériau getter 104). Enfin, la courbe 14 représente la capacité de pompage de ce même matériau getter 104, mais ne comportant pas de couche de protection.

On voit clairement sur la figure 4 que la présence d'une couche de protection à base d'oxyde ou de nitrure permet d'accroitre la capacité de pompage du matériau getter par rapport à un même matériau getter ne comportant pas de couche de protection et qui a été exposé à l'air ambiant. De plus, on voit sur la courbe 14 qu'entre 350°C et 375°C, c'est-à-dire avant la fin de l'activation thermique du matériau getter ne comportant pas de couche de protection, le matériau getter non protégé réalise un dégazage (qui se traduit que la figure 4 par une baisse de la capacité de pompage), ce qui représente un inconvénient majeur car un tel dégazage apparaissant lors de l'activation thermique du matériau getter, c'est-à-dire après la fermeture de la cavité dans laquelle le matériau getter et le dispositif sont encapsulés, augmente la pression régnant dans la cavité, ce qui peut perturber le fonctionnement du dispositif. Comparativement, on voit sur les courbes 10 et 12 qu'un tel dégazage ne se produit pas lorsque le matériau getter est protégé par une couche de protection à base d'oxyde ou de nitrure (aucune baisse de la capacité de pompage n'apparaissant sur les courbes 10 et 12 lors de l'activation thermique du matériau getter).

Le procédé d'encapsulation décrit ci-dessus au cours duquel on forme une couche de protection par oxydation et/ou nitruration sèche du matériau getter s'applique particulièrement pour la fabrication de microsystèmes ou de nanosystèmes de types MEMS, NEMS, MOEMS, NOEMS ou détecteurs infrarouge nécessitant une atmosphère contrôlée. De plus, bien que l'encapsulation du matériau getter 104 et du dispositif 100 décrite ci-dessus soit réalisée par un assemblage de deux substrats, cette encapsulation du dispositif 100 et du matériau getter 104 dans une cavité hermétique pourrait être réalisée par un dépôt en couche mince du capot de la cavité sur le substrat 110 (le matériau getter 104 étant dans ce cas réalisé à côté du dispositif 100).

Dans une variante, il est possible que le matériau getter ne soit pas déposé sur le substrat 102 mais sur le second substrat 110, par exemple disposé à côté du dispositif 100.

## Revendications

1. Procédé de traitement d'un matériau getter (104) à base de titane et/ou de zirconium, **caractérisé en ce qu'**il comporte au moins une étape d'oxydation et/ou de nitruration du matériau getter (104) mise en oeuvre sous atmosphère sèche de dioxygène et/ou de diazote à une pression supérieure à environ 10⁻² mbar et à une température comprise entre environ 50°C et 120°C et pendant une durée comprise entre environ 1 minute et 10 minutes, formant une couche de protection (106) à base d'oxyde et/ou de nitrure du matériau getter (104).

2. Procédé selon la revendication 1, comportant en outre, avant l'étape d'oxydation et/ou de nitruration, une étape de mise sous vide ou de maintien sous vide de l'environnement dans lequel se trouve le matériau getter (104).

3. Procédé selon l'une des revendications précédentes, comportant en outre, lorsque le matériau getter (104) est exposé à l'air ambiant avant la mise en oeuvre de l'étape d'oxydation et/ou de nitruration, une étape de traitement thermique du matériau getter (104) à une température proche de sa température d'activation thermique et sous vide secondaire mise en oeuvre avant l'étape d'oxydation et/ou de nitruration du matériau getter (104).

4. Procédé selon la revendication 3, dans lequel l'étape de traitement thermique est mise en oeuvre pendant une durée comprise entre environ 1 heure et 10 heures.

5. Procédé selon l'une des revendications précédentes, dans lequel le matériau getter (104) est réalisé en couche mince.

6. Procédé selon l'une des revendications précédentes, dans lequel le matériau getter (104) comporte une taille de grains inférieure ou égale à environ 200 nm.

7. Procédé d'encapsulation d'un matériau getter (104) dans une cavité (114), comportant au moins les étapes de :
- dépôt d'au moins le matériau getter (104) sur une face d'une couche (102) destinée à former une paroi de la cavité (114),
- mise en oeuvre d'un procédé de traitement du matériau getter (104) selon l'une des revendications 1 à 6,
- fermeture de la cavité (114) dans laquelle est disposé le matériau getter (104).

8. Procédé selon la revendication 7, comportant en outre, entre le procédé de traitement du matériau getter (104) et l'étape de fermeture de la cavité (114), la mise en oeuvre d'une étape de traitement thermique du matériau getter (104) à une température inférieure d'environ 50°C à 150°C par rapport à la température d'activation du matériau getter (104) et sous vide secondaire.

9. Procédé selon la revendication 8, dans lequel l'étape de traitement thermique du matériau getter (104) réalisée entre le procédé de traitement du matériau getter (104) et l'étape de fermeture de la cavité (114) est mise en oeuvre pendant une durée comprise entre environ quelques minutes et quelques dizaines de minutes.

10. Procédé selon l'une des revendications 7 à 9, comportant en outre, après la mise en oeuvre du procédé de traitement du matériau getter (104) ou, lorsque le procédé comporte une étape de traitement thermique du matériau getter (104) mise en oeuvre entre le procédé de traitement du matériau getter (104) et l'étape de fermeture de la cavité (114), après ladite étape de traitement thermique du matériau getter (104), une étape d'activation thermique du matériau getter (104) .

11. Procédé selon la revendication 10, dans lequel l'étape d'activation thermique du matériau getter (104) est réalisée pendant l'étape de fermeture de la cavité (114).

12. Procédé selon l'une des revendications 10 ou 11, dans lequel l'activation thermique du matériau getter (104) est réalisée en chauffant le matériau getter (104) à une température comprise entre environ 200°C et 450°C.

13. Procédé selon l'une des revendications 7 à 12, dans lequel un dispositif microélectronique et/ou nanoélectronique (100) est également encapsulé dans la cavité (114).

14. Procédé selon l'une des revendications 1 à 13, dans lequel le matériau getter (104) comporte au moins en surface la couche de protection (106) à base d'au moins un oxyde non natif et/ou de nitrure du matériau getter (104) et d'épaisseur comprise entre environ 1 nm et 10 nm.

## Patentansprüche

1. Verfahren zur Bearbeitung eines Gettermaterials (104) auf Basis von Titan und/oder von Zirkon, **dadurch gekennzeichnet, dass** es wenigstens einen Schritt der Oxidation und/oder der Nitrierung des Gettermaterials (104) umfasst, der in einer trockenen Disauerstoff- und/oder Distickstoff-Atmosphäre bei einem Druck über ungefähr 10⁻² mbar und bei einer Temperatur durchgeführt wird, die zwischen ungefähr 50°C und 120°C enthalten ist, sowie während einer Dauer, die zwischen ungefähr 1 Minute und 10 Minuten enthalten ist, wodurch eine Schutzschicht (106) auf Basis von Oxid und/oder von Nitrid des Gettermaterials (104) gebildet wird.

2. Verfahren nach Anspruch 1, ferner umfassend, vor dem Schritt der Oxidation und/oder der Nitrierung, einen Schritt des Evakuierens oder des Unter-Vakuum-Haltens der Umgebung, in der sich das Gettermaterial (104) befindet.

3. Verfahren nach einem der vorhergehenden Ansprüche, ferner umfassend, wenn das Gettermaterial (104) vor der Durchführung des Schritts der Oxidation und/oder der Nitrierung der Umgebungsluft ausgesetzt ist, einen Schritt der thermischen Behandlung des Gettermaterials (104) bei einer Temperatur nahe seiner thermischen Aktivierungstemperatur und unter Sekundärvakuum, der vor dem Schritt der Oxidation und/oder der Nitrierung des Gettermaterials (104) durchgeführt wird.

4. Verfahren nach Anspruch 3, wobei der Schritt der thermischen Bearbeitung während einer Dauer durchgeführt wird, die zwischen ungefähr 1 Stunde und 10 Stunden enthalten ist.

5. Verfahren nach einem der vorhergehenden Ansprüche, wobei das Gettermaterial (104) als dünne Schicht realisiert ist.

6. Verfahren nach einem der vorhergehenden Ansprüche, wobei das Gettermaterial (104) eine Korngröße umfasst, die kleiner oder gleich ungefähr 200 nm ist.

7. Verfahren zur Einkapselung eines Gettermaterials (104) in einem Hohlraum (114), wenigstens umfassend die folgenden Schritte:
- Aufbringen wenigstens des Gettermaterials (104) auf einer Fläche einer Schicht (102), die dazu ausgelegt ist, eine Wand des Hohlraums (114) zu bilden,
- Durchführen eines Verfahrens zur Bearbeitung des Gettermaterials (104) nach einem der Ansprüche 1 bis 6,
- Schließen des Hohlraums (114), in dem das Gettermaterial (104) angeordnet ist.

8. Verfahren nach Anspruch 7, ferner umfassend, zwischen dem Verfahren zur Bearbeitung des Gettermaterials (104) und dem Schritt des Schließens des Hohlraums (114), die Durchführung eines Schritts der thermischen Behandlung des Gettermaterials (104) bei einer Temperatur, die um ungefähr 50°C bis 150°C niedriger ist als die Aktivierungstemperatur des Gettermaterials (104) und unter Sekundärvakuum.

9. Verfahren nach Anspruch 8, bei dem der Schritt der thermischen Behandlung des Gettermaterials (104), der zwischen dem Verfahren zur Bearbeitung des Gettermaterials (104) und dem Schritt des Schließens des Hohlraums (114) realisiert wird, während einer Dauer durchgeführt wird, die zwischen ungefähr einigen Minuten und einigen zehn Minuten enthalten ist.

10. Verfahren nach einem der Ansprüche 7 bis 9, ferner umfassend, nach der Durchführung des Verfahrens zur Bearbeitung des Gettermaterials (104) oder, wenn das Verfahren einen Schritt der thermischen Behandlung des Gettermaterials (104) umfasst, der zwischen dem Verfahren zur Bearbeitung des Gettermaterials (104) und dem Schritt des Schließens des Hohlraums (114) durchgeführt wird, nach dem Schritt der thermischen Behandlung des Gettermaterials (104), einen Schritt der thermischen Aktivierung des Gettermaterials (104).

11. Verfahren nach Anspruch 10, wobei der Schritt der thermischen Aktivierung des Gettermaterials (104) während des Schritts des Schließens des Hohlraums (114) realisiert wird.

12. Verfahren nach einem der Ansprüche 10 oder 11, wobei die thermische Aktivierung des Gettermaterials (104) realisiert wird, indem das Gettermaterial (104) auf eine Temperatur erhitzt wird, die zwischen ungefähr 200°C und 450°C enthalten ist.

13. Verfahren nach einem der Ansprüche 7 bis 12, wobei eine mikroelektronische und/oder nanoelektronische Vorrichtung (100) ebenfalls in dem Hohlraum (114) eingekapselt wird.

14. Verfahren nach einem der Ansprüche 1 bis 13, wobei das Gettermaterial (104) wenigstens an der Oberfläche die Schutzschicht (106) auf Basis wenigstens eines nicht nativen Oxids und/oder eine Nitrids des Gettermaterials (104) und mit einer Dicke umfasst, die zwischen ungefähr 1 nm und 10 nm enthalten ist.

## Claims

1. A treatment method for a getter material (104) comprising titanium and/or zirconium, **characterized in that** it comprises at least one oxidation and/or nitriding step of the getter material (104) conducted under dry atmosphere of dioxygen and/or dinitrogen at a pressure greater than approximately 10⁻² mbar and at a temperature between approximately 50°C and 120°C and over a period between approximately 1 minute and 10 minutes, forming a protective layer (106) comprising oxide and/or nitride of the getter material (104).

2. The method according to claim 1, further comprising, prior to the oxidation and/or nitriding step, a step for vacuuming or keeping under vacuum of the environment containing the getter material (104).

3. The method according to one of the preceding claims, further comprising, when the getter material (104) is exposed to ambient air prior to carrying out the oxidation and/or nitriding step, a thermal treatment step of the getter material (104) at a temperature close to its thermal activation temperature and under secondary vacuum conducted prior to the oxidation and/or nitriding step of getter material (104).

4. The method according to claim 3, in which the thermal treatment step is carried out over a period between approximately 1 hour and 10 hours.

5. The method according to one of the preceding claims, in which the getter material (104) is made as a thin layer.

6. The method according to one of the preceding claims, in which the getter material (104) comprises a grain size of less than or equal to approximately 200 nm.

7. An encapsulation method of a getter material (104) in a cavity (114), comprising at least the steps of:
- depositing at least the getter material (104) on one face of a layer (102) intended to form a wall of the cavity (114),
- conducting a treatment method of the getter material (104) according to one of claims 1 to 6,
- closing of the cavity (114) containing the getter material (104).

8. The method according to claim 7, further comprising, between the treatment method of the getter material (104) and the closing step of the cavity (114), conducting a thermal treatment step of the getter material (104) at a temperature less than approximately 50°C to 150°C relative to the activation temperature of the getter material (104) and under secondary vacuum.

9. The method according to claim 8, in which the thermal treatment step of the getter material (104) carried out between the treatment method of the getter material (104) and the closing step of the cavity (114) is executed over a period of between approximately few minutes and some tens of minutes.

10. The method according to one of claims 7 to 9, further comprising a thermal activation step of the getter material (104) after execution of the treatment method of the getter material (104) or, when the method comprises a thermal treatment step of the getter material (104) conducted between the treatment method of the getter material (104) and the closing step of the cavity (114), after said thermal treatment step of the getter material (104).

11. The method according to claim 10, in which the thermal activation step of the getter material (104) is taken during the closing step of the cavity (114).

12. The method according to one of claims 10 or 11, in which thermal activation of the getter material (104) is carried out by heating the getter material (104) to a temperature between approximately 200°C and 450°C.

13. The method according to one of claims 7 to 12, in which a microelectronic and/or nanoelectronic device (100) is also encapsulated in the cavity (114).

14. The method according to one of claims 1 to 13, in which the getter material (104) comprises at least on the surface one protective layer (106) comprising at least one non-native oxide and/or nitride of the getter material (104) and of a thickness between approximately 1 nm and 10 nm.
